(19) 

**Europäisches Patentamt**
**European Patent Office**
**Office européen des brevets**

(11)  **EP 2 752 985 B1**

(12)  **EUROPEAN PATENT SPECIFICATION**

(45) Date of publication and mention
of the grant of the patent:
**01.11.2017 Bulletin 2017/44**

(51) Int Cl.:
*H01L 37/02* (2006.01)

(21) Application number: **12829074.9**

(22) Date of filing: **28.08.2012**

(86) International application number:
**PCT/JP2012/071712**

(87) International publication number:
**WO 2013/031774 (07.03.2013 Gazette 2013/10)**

(54) **POWER GENERATION SYSTEM**

STROMERZEUGUNGSSYSTEM

SYSTÈME DE GÉNÉRATION DE PUISSANCE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **31.08.2011 JP 2011189971**
**25.10.2011 JP 2011233715**

(43) Date of publication of application:
**09.07.2014 Bulletin 2014/28**

(73) Proprietors:
• **Daihatsu Motor Co., Ltd.**
**Ikeda-shi, Osaka 563-8651 (JP)**
• **National University Corporation Nagaoka
University
of Technology
Nagaoka-shi
Niigata
940-2188 (JP)**

(72) Inventors:
• **KIM, Yoonho**
**Gamo-gun**
**Shiga 520-2593 (JP)**
• **KIM, Juyoung**
**Gamo-gun**
**Shiga 520-2593 (JP)**
• **SERIZAWA, Takeshi**
**Gamo-gun**
**Shiga 520-2593 (JP)**
• **TANAKA, Hirohisa**
**Gamo-gun**
**Shiga 520-2593 (JP)**

• **NAKAYAMA, Tadachika**
**Nagaoka-shi**
**Niigata 940-2188 (JP)**
• **TAKEDA, Masatoshi**
**Nagaoka-shi**
**Niigata 940-2188 (JP)**
• **YAMADA, Noboru**
**Nagaoka-shi**
**Niigata 940-2188 (JP)**
• **NIIHARA, Koichi**
**Nagaoka-shi**
**Niigata 940-2188 (JP)**
• **OGAWA, Kyohei**
**Nagaoka-shi**
**Niigata 940-2188 (JP)**
• **ISHIZAWA, Satoshi**
**Nagaoka-shi**
**Niigata 940-2188 (JP)**
• **SHIDA, Masashi**
**Nagaoka-shi**
**Niigata 940-2188 (JP)**

(74) Representative: **Schwabe - Sandmair - Marx
Patentanwälte Rechtsanwalt
Partnerschaft mbB
Joseph-Wild-Straße 20
81829 München (DE)**

(56) References cited:
**DE-A1-102009 016 209    DE-C1- 3 938 890**
**JP-A- H11 332 266       JP-A- 2007 288 923**
**JP-A- 2008 156 201      US-A1- 2006 102 224**
**US-A1- 2010 289 377**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

TECHNICAL FIELD

The present invention relates to a power-generating system.

BACKGROUND ART

Conventionally, a large amount of heat energy is released and lost as, for example, waste heat, light, etc. in various energy-using devices such as internal combustion engines including an automobile engine; heat exchangers including a boiler and air-conditioning equipment; motor generators including a power generator and a motor; and luminous devices including lightings.

Nowadays, recovery and recycling of released heat energy as an energy source has been required in view of energy conservation, and as such a method, a pyroelectric generation in which a pyroelectric element is used is known.

To be specific, for example, Patent Document 1 below has proposed a method using a power-generating apparatus including a heat source that allows the temperatures of the plurality of pyroelectric elements to increase; a cooling source that allows the temperatures of the pyroelectric elements to decrease; and a moving unit that moves the heat source and the cooling source, and/or the pyroelectric elements, and by increasing and decreasing the temperature of the pyroelectric elements by the heat source and cooling source periodically, direct-current power or alternating-current power is taken out from the pyroelectric element. Patent Document 2 discloses a thermoelectric generator wherein a ferroelectric device is alternately heated and cooled between a first temperature lower than the Curie temperature and a second temperature higher than the Curie temperature, so that the ferroelectric material undergoes phase transitions between the ferroelectric phase and the paraelectric phase. An electric field is applied when the ferroelectric material is in, or entering into, the ferroelectric phase.

Patent Document 1 Japanese Unexamined Patent Publication No. H11-332266
Patent Document

US 2010/289377 A1

SUMMARY OF THE INVENTION

PROBLEM TO BE SOLVED BY THE INVENTION

Meanwhile, such a power-generating method requires power generation with more excellent efficiency.

An object of the present invention is to provide a power-generating system capable of more excellently efficient generation of electricity.

MEANS FOR SOLVING THE PROBLEM

To achieve the above object, a power-generating system of the present invention includes
a heat source which is able to produce temporal temperature variation;
a first device which is able to produce temporal temperature variation based on the temperature change of the heat source and in which polarization occurs;
a second device for taking out a net generating power from the first device;
a detection unit that detects the temperature of the first device;
an electric field application unit that applies an electric field to the first device; and
a control unit for activating the electric field application unit according to claim 1.

EFFECTS OF THE INVENTION

With the power-generating system of the present invention, power generation efficiency can be improved.

BRIEF DESCRIPTION OF THE DRAWINGS

FIG. 1 is a schematic diagram illustrating the configuration of a first embodiment of the power-generating system according to the present invention.
FIG. 2 is a schematic diagram illustrating the configuration of the first embodiment of the power-generating system of the present invention on board.
FIG. 3 is an enlarged view of a relevant part of the power-generating system shown in FIG. 2.
FIG. 4 is a schematic diagram illustrating the configuration of a second embodiment of the power-generating system outside the scope of the present invention.
FIG. 5 is a schematic diagram illustrating the configuration of an embodiment of the first device shown in FIG. 4.
FIG. 6 is a schematic diagram illustrating the configuration of another embodiment of the first device shown in FIG. 4.
FIG. 7 is a schematic diagram illustrating the configuration of the second embodiment of the power-generating system on board.
FIG. 8 is an enlarged view of a relevant part of the power-generating system shown in FIG. 7.
FIG. 9 is a graph illustrating the relationship between the generated voltage and the temperature change obtained in Example 1.
FIG. 10 is a graph illustrating the relationship between the generated voltage and the temperature change in Example 2.
FIG. 11 is a graph illustrating the relationship between the generated voltage and the temperature change in Example 3.

FIG. 12 is a graph illustrating the relationship between the generated voltage and the temperature change in Comparative Example 1.

EMBODIMENT OF THE INVENTION

<First Embodiment>

In the following, the first Embodiment of the present invention is described.

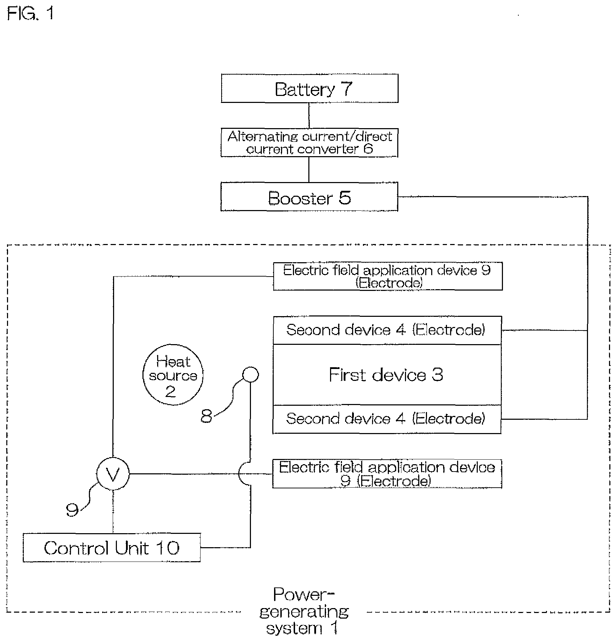

FIG. 1 is a schematic diagram illustrating the configuration of a first embodiment of the power-generating system of the present invention.

In FIG. 1, a power-generating system 1 includes a heat source 2 which is able to produce temporal temperature variation; a first device 3 which is able to produce temporal temperature variation based on the temperature change of the heat source 2 and in which polarization occurs; a second device 4 that takes out a net generating power from the first device 3; a temperature sensor 8 as a detection unit that detects the temperature of the first device 3; an electric field application device 9 as an electric field application unit that applies an electric field to the first device; and a control unit 10 as a control unit for activating the electric field application device 9 when the temperature detected by the temperature sensor 8 is the Curie temperature of the first device 3 or higher.

The heat source 2 is not particularly limited, as long as the heat source has a temporal temperature variation, and examples thereof include various energy-using devices such as internal combustion engines, and luminous devices.

The internal combustion engine is, for example, a device that outputs motive power for vehicles. For example, a single cylinder or a multicylinder type is used, and in the single cylinder or multicylinder, a multi-stroke cycle (e.g., two-stroke cycle, four-stroke cycle, and six-stroke cycle, etc.) is used.

In such an internal combustion engine, pistons repeatedly move up and down in the cylinders, and such up-down moves of the pistons allow, for example, in the four-stroke cycle system, performance of an intake stroke, a compression stroke, a power stroke, and an exhaust stroke sequentially, and combustion of fuel, to output motive power.

In such an internal combustion engine, in the exhaust stroke, a high temperature exhaust gas is discharged via the exhaust gas pipe. The heat energy is conducted with the exhaust gas as a heating medium, and the internal temperature of the exhaust gas pipe increases.

Meanwhile, in other strokes (strokes excluding the exhaust stroke), the exhaust gas amount in the exhaust gas pipe decreases, and therefore the internal temperature of the exhaust gas pipe decreases compared with the exhaust stroke.

Thus, the temperature of the internal combustion engine increases in the exhaust stroke, decreases in the intake stroke, compression stroke, and power stroke: that is, the temporal temperature variation is produced.

In particular, the above-described strokes are repeated periodically and sequentially in accordance with the piston cycle, and therefore the internal temperature of the exhaust gas pipes of the cylinders of the internal combustion engine changes periodically in accordance with the cycle of the repetition of the above-described strokes, to be more specific, a high-temperature state and a low-temperature state are repeated periodically.

The temperature of the luminous device increases when the luminous device is turned on (emission), for example, by heat energy of light such as infrared radiation and visible light as a heating medium, while when the luminous device is turned off, its temperature decreases. Thus, the temperature of the luminous devices changes over time when turned on (emission) or off over time.

In particular, for example, when the luminous device is a luminous device that repeats turning on and off of light over time intermittently (blinking (switching) luminous device), the temperature of the luminous device changes periodically by heat energy of light at the time when turned on (emission), to be more specific, a high-temperature state and a low-temperature state are repeated periodically.

Examples of the heat source 2 further include a plurality of heat sources, and a temperature change can also be caused by switching between the plurality of heat sources.

To be more specific, for example, in an embodiment, the heat source includes two heat sources, i.e., a low temperature heat source (coolant, etc.) and a high temperature heat source (e.g., heating material, etc.) having a temperature higher than the low temperature heat source; and the low temperature heat source and the high temperature heat source are switched back and forth alternately over time.

In this manner, the temperature of the heat source can be increased or decreased over time, and in particular, by repeating the switching back and forth between the low temperature heat source and the high temperature heat source periodically, the periodic temperature change can be achieved.

The heat source 2 including a plurality of switchable heat sources is not particularly limited, and examples thereof include a high temperature air furnace (e.g., a high-temperature gas generator described in WO96-05474) including a combustion low temperature air supplier, a regenerator heat exchanger, a high temperature gas exhauster, and a supply/exhaust switch valve; and a seawater exchange system (hydrogen storage alloy actuator seawater exchange system) using a high temperature heat source, a low temperature heat source, and a hydrogen storage alloy.

As the heat source 2, the above-described heat sources may be used singly or in combination of two or more.

As the heat source 2, preferably, a heat source that undergoes a periodic temperature change over time is used.

As the heat source 2, preferably, an internal combustion engine is used.

The first device 3 is a device that undergoes polarization in accordance with the temperature change of the heat source 2.

The polarization here is defined as the following: a phenomenon of electromotive force occurrence in a material, including, for example, a phenomenon of occurrence of a potential difference by dielectric polarization due to displacement of plus and minus ions based on the deformation of a crystal, such as the piezoelectric effect; and/or a phenomenon of occurrence of a potential difference by changes in the dielectric constant due to a temperature change, such as the pyroelectric effect.

Examples of the first device 3 include, to be more specific, a device that undergoes polarization by the piezoelectric effect, and a device that undergoes polarization by the pyroelectric effect.

In the piezoelectric effect (phenomenon), when a pressure or a deformation is applied, polarization is caused in accordance with the degree of the pressure or the deformation.

The first device 3 that undergoes polarization by the piezoelectric effect is not particularly limited, and a known piezoelectric element may be used.

When a piezoelectric element is used as the first device 3, the piezoelectric element is disposed, for example, so that the piezoelectric element is brought into contact with the heat source 2 or into contact with (exposed to) the heating medium (the above-described exhaust gas, light, etc.) that conduct the heat of heat source 2 while the surrounding thereof is fixed by a fixing member to suppress the volume expansion thereof.

The fixing member is not particularly limited, and for example, the second device 4 (e.g., electrode, etc.) to be described later may also be used.

In this case, the piezoelectric element is heated or cooled by the temperature change (or sometimes through a heating medium (the above-described exhaust gas, light, etc.)) over time of the heat source 2, which allows expansion or shrinkage thereof.

In such a case, the volume expansion of the piezoelectric element is suppressed by the fixing member, and therefore the piezoelectric element is pressed by the fixing member, which allows polarization to occur by the piezoelectric effect or phase transformation near the Curie temperature. In this manner, although to be described later, a net generating power is taken out from the piezoelectric element via the second device 4.

In such a piezoelectric element, usually, a heated state or a cooled state is kept, and when its temperature becomes constant (that is, the volume is constant), the polarization is neutralized, and by cooling or heating thereafter, the piezoelectric element undergoes polarization again.

Thus, as described above, when the temperature of the heat source 2 changes periodically, and a high-temperature state and a low-temperature state are periodically repeated, the piezoelectric element is heated and cooled repeatedly and periodically, and therefore polarization and neutralization of the piezoelectric element are periodically repeated.

As a result, a net generating power can be taken out as a periodically changing waveform (e.g., alternating current, pulsating current, etc.) by the second device 4 to be described later.

The pyroelectric effect is, for example, the effects (phenomenon) such as the following: when an insulator (dielectric) is heated or cooled, the insulator undergoes polarization in accordance with the temperature change. The pyroelectric effect includes a first effect and a second effect.

In the first effect, at the time of heating or cooling of the insulator, spontaneous polarization occurs by the temperature change, and an electric charge is generated on the insulator surface.

In the second effect, at the time of heating or cooling of the insulator, pressure deflection is caused in the crystal structure by the temperature change, and the pressure or the deformation on the crystal structure causes piezoelectric polarization (piezoelectric effect).

Such a device that undergoes polarization by the pyroelectric effect is not particularly limited, and a known pyroelectric element may be used.

When a pyroelectric element is used as the first device 3, the pyroelectric element is disposed, for example, so as to be in contact with the heat source 2, or so as to be in contact (exposed to) with the heating medium (the above-described exhaust gas, light, etc.) that conducts the heat of the heat source 2.

In such a case, the pyroelectric element is heated or cooled by temperature changes (or sometimes through a heating medium (the above-described exhaust gas, light, etc.)) over time of the heat source 2, and undergoes polarization by its pyroelectric effect (including the first effect and second effect). In this manner, although to be described later, a net generating power is taken out from the pyroelectric element via the second device 4.

In such a pyroelectric element, usually, a heated state or a cooled state is kept, and when its temperature becomes constant, the polarization is neutralized, and by cooling or heating thereafter, the pyroelectric element undergoes polarization again.

Thus, as described above, when the temperature of the heat source 2 changes periodically, and a high-temperature state and a low-temperature state are periodically repeated, the pyroelectric element is heated and cooled periodically and repeatedly, and therefore the polarization and neutralization of the pyroelectric element are periodically repeated.

As a result, a net generating power can be taken out as a periodically changing waveform (e.g., alternating current, pulsating current, etc.) by the second device 4 to be described later.

These first devices 3 may be used singly or in combination of two or more.

Examples of the first device 3 that may be used are, as described above, to be specific, a known pyroelectric element (e.g., $BaTiO_3$, $CaTiO_3$, $(CaBi)TiO_3$, $BaNd_2Ti_5O_{14}$, $BaSm_2Ti_4O_{12}$, lead zirconate titanate ($PZT:Pb(Zr,Ti)O_3$), etc.), and a known piezoelectric element (e.g., crystal ($SiO_2$), zinc oxide (ZnO), Rochelle salt (potassium sodium tartrate) ($KNaC_4H_4O_6$), lead zirconate titanate ($PZT: Pb (Zr,Ti)O_3$), lithium niobate ($LiNbO_3$), lithium tantalate ($LiTaO_3$), lithium tetraborate ($Li_2B_4O_7$), langasite ($La_3Ga_5SiO_{14}$), aluminum nitride (AlN), tourmaline, polyvinylidene fluoride (PVDF), etc.) $Ca_3(VO_4)_2$, $Ca_3(VO_4)_2/Ni$, $LiNbO_3$, $LiNbO_3/Ni$, $LiTaO_3$, $LiTaO_3/Ni$, $Li(Nb_{0.4}Ta_{0.6})O_3$, $Li(Nb_{0.4}Ta_{0.6})O_3/Ni$, $Ca_3\{(Nb,Ta)O_4\}_2$, and $Ca_3\{(Nb,Ta)O_4\}_2/Ni$.

The Curie temperature of the first device 3 is, for example, -77°C or higher, preferably -10°C or higher, and for example, 1300°C or lower, preferably 900°C or lower.

The relative dielectric constant of the first device 3 (insulator (dielectric)) is, for example, 1 or higher, preferably 100 or higher, and even more preferably 2000 or higher.

In such a power-generating system 1, higher the relative dielectric constant of the first device 3 (insulator (dielectric)) is, the higher the energy conversion efficiency is, which allows for obtainment of a net generating power at high voltage. However, when the relative dielectric constant of the first device 3 is below the above-described lower limit, the energy conversion efficiency is low, and the voltage of the obtained net generating power may be low.

In the first device 3 (insulator (dielectric)), polarization occurs by the temperature change of the heat source 2, and the polarization may be any of electronic polarization, ionic polarization, and orientation polarization.

For example, it has been expected that with those materials in which polarization occurs by orientation polarization (e.g., liquid crystal material, etc.), improvement in power generation efficiency can be achieved by changing its molecule structure.

In FIG. 1, the second device 4 is provided so as to take out a net generating power from the first device 3.

Such a second device 4 is not particularly limited, and includes, for example, two electrodes (e.g., copper electrode, silver electrode, etc.) that are disposed to face each other with the above-described first device 3 sandwiched therebetween, and lead wires to be connected to these electrodes; and is electrically connected to the first device 3.

The temperature sensor 8 is provided in the proximity of or in contact with the first device 3 to detect the temperature of the first device 3. The temperature sensor 8 directly detects the surface temperature of the first device 3, or detects the ambient temperature of the surrounding of the first device 3, as the temperature of the first device 3, and for example, a known temperature sensor such as an infrared thermometer and a thermocouple thermometer are used.

The electric field application device 9 is provided directly or in the proximity of the first device 3 to apply an electric field to the first device 3. To be specific, the electric field application device 9 includes, for example, separately from the above-described second device 4, two electrodes (for example, copper electrode, silver electrode, etc.) that are disposed to face each other with the first device 3 interposed therebetween, a voltage application power source V, and lead wires connected to these, and is disposed so as to be distant from the first device 3 and so that the first device 3 is interposed between their electrodes.

The control unit 10 is a unit (for example, ECU: Electronic Control Unit) that carries out electrical control in the power-generating system 1, and is configured from a micro computer including a CPU, a ROM, and a RAM.

The control unit 10 is electrically connected to the temperature sensor 8 and the electric field application device 9, and as described later, activates the electric field application device 9 when the temperature detected by the above-described temperature sensor 8 is the Curie temperature of the first device 3 or higher.

In a power-generating system 1 shown in FIG. 1, the second device 4 is electrically connected to, in sequence, a booster 5, an alternating current/direct current converter (AC-DC converter) 6, and a battery 7.

To generate electricity by such a power-generating system 1, for example, first, the temperature of the heat source 2 is increased or decreased over time; preferably, the temperature is changed periodically to heat/or cool the first device 3 by the heat source 2.

In accordance with such a temperature change, polarization is caused preferably periodically in the above-described first device 3. Thereafter, through the second device 4, a net generating power is taken out as a periodically changing waveform (e.g., alternating current, pulsating current, etc.) in accordance with the periodical polarization of the first device 3.

In such a power-generating system 1, the temperature of the heat source 2 is, in a high-temperature state, for example, 200 to 1200°C, preferably 700 to 900°C; in a low-temperature state, below the above-described high-temperature state temperature, to be more specific, for example, 100 to 800°C, preferably 200 to 500°C; and the temperature difference between the high-temperature state and the low-temperature state is, for example, 10 to 600°C, preferably 20 to 500°C.

The repetition cycle of the high-temperature state and low-temperature state is, for example, 10 to 400 cycles/sec, preferably 30 to 100 cycles/sec.

Meanwhile, in such a power-generating system 1, depending on the temperature conditions, the temperature of the first device 3 may exceed its Curie temperature. Then, when the first device 3 is used under the environment of the Curie temperature of the first device 3 or higher, the first device 3 may be damaged, which may reduce power generation performance or power generation may not be achieved.

Thus, in the power-generating system 1, the temperature sensor 8 detects the temperature of the first device 3, and when the detected temperature is the Curie temperature of the first device 3 or higher, the control unit 10 activates the electric field application device 9 and an electric field is applied to the first device 3.

To be more specific, the temperature sensor 8 continuously detects the temperature of the first device 3, which is able to produce temporal temperature variation based on the temperature change of the heat source 2, and a voltage is applied to the electrode of the electric field application device 9 and an electric field is applied to the first device 3 from the point when the detected temperature is the Curie temperature of the first device 3 or higher until the temperature is below the Curie temperature.

The intensity of the electric field is, for example, 0.1 to 5kV/mm, preferably 0.3 to 3.5kV/mm, more preferably 1 to 2kV/mm.

Then, from the point when the temperature detected by the temperature sensor 8 is below the Curie temperature of the first device 3, the application of the electric field is stopped again until the temperature is the Curie temperature or higher.

In this manner, damages to the first device 3 can be suppressed even if the first device 3 is exposed to an environment in which the temperature is higher than the Curie temperature.

The net generating power thus taken out from the power-generating system 1 is boosted in the booster 5 connected to the second device 4, as in a state of a periodically changing waveform (e.g., alternating current, pulsating current, etc.). For the booster 5, a booster that is capable of boosting the alternating current voltage with excellent efficiency with a simple structure using, for example, a coil, condenser, etc is used.

Then, the net generating power with its voltage boosted by the booster 5 is converted to a direct current voltage in the alternating current/direct current converter 6, and thereafter, stored in the battery 7.

With such a power-generating system 1, the heat source 2 having a temporal temperature variation is used, and therefore a changing voltage (e.g., alternating current voltage) can be taken out, and as a result, compared with the case where a constant voltage (direct current voltage) is taken out, a net generating power can be stored with a simple structure and excellent boosting efficiency.

Furthermore, when the heat source 2 is a heat source that undergoes a periodic temperature change, the net generating power can be taken out as a periodically changing waveform, and as a result, the net generating power can be stored with a simple structure and excellent boosting efficiency.

Particularly, with such a power-generating system 1, improvement in power generation efficiency can be achieved.

That is, in such a power-generating system 1, when the temperature of the first device 3 is detected by the temperature sensor 8 and the detected temperature is the Curie temperature of the first device 3 or higher, the control unit 10 activates the electric field application device 9, and an electric field is applied to the first device 3.

Thus, even if the first device 3 is exposed to an environment in which the temperature is higher than the Curie temperature, damages to the first device 3 can be suppressed, and reduction in power generation performance and power generation failure of the power-generating system 1 can be suppressed. As a result, electricity can be generated with excellent efficiency even under a high-temperature environment.

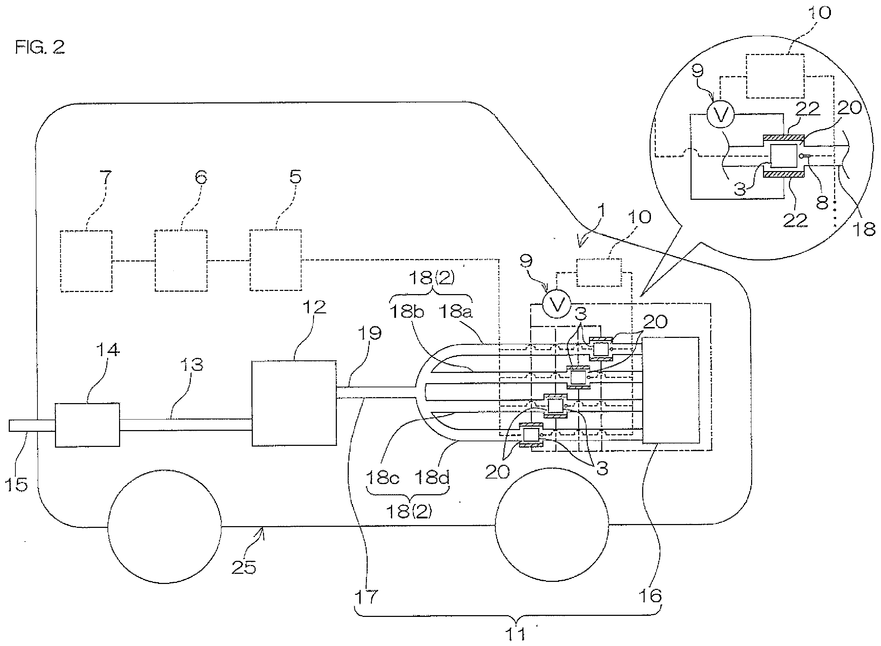

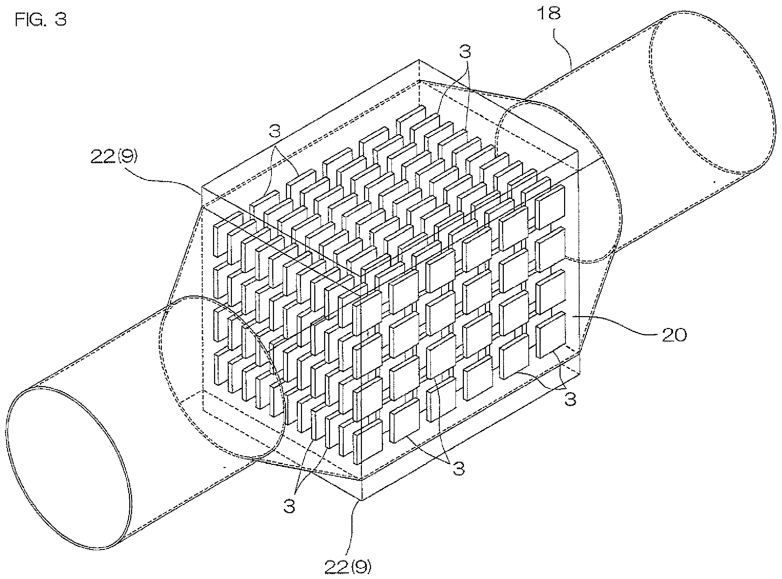

FIG. 2 is a schematic diagram illustrating the configuration of a first embodiment of a power-generating system of the present invention on board, and FIG. 3 is an enlarged view of a relevant part of the power-generating system shown in FIG. 2.

In FIG. 2, an automobile 25 includes an internal combustion engine 11, a catalyst mount portion 12, an exhaust pipe 13, a muffler 14, and an outlet pipe 15.

The internal combustion engine 11 includes an engine 16, and an exhaust manifold 17.

The engine 16 is a multicylinder (four cylinder), multi-stroke cycle (four-stroke cycle) engine, and upstream end portions of branch pipes 18 (described later) of the exhaust manifold 17 are connected to the cylinders.

The exhaust manifold 17 is provided for collecting the exhaust gas discharged from the cylinders of the engine 16; and includes a plurality of (four) branch pipes 18 (when these have to be distinguished, these are referred to as, from the top in FIG. 2, a branch pipe 18a, a branch pipe 18b, a branch pipe 18c, and a branch pipe 18d.) connected to the cylinders of the engine 16, and a collection pipe 19 that integrates the branch pipes 18 at a downstream side of the branch pipes 18.

Each of the branch pipes 18 includes one box space 20 on its way in the flow direction. The box space 20 is a substantially rectangular parallelepiped space intervened in and communicating with the branch pipe 18, and inside therein, includes a plurality of first devices 3, and the second devices 4, which are not shown (ref: FIG. 3).

In FIG. 2, the plurality of first devices 3 are simplified, and one first device 3 per one box space 20 is shown.

In such an exhaust manifold 17, the upstream end portions of the branch pipes 18 are connected to the cylinders of the engine 16, and the downstream end portions of the branch pipes 18 are connected to the upstream end portion of the collection pipe 19. The downstream end portion of the collection pipe 19 is connected to the upstream end portion of the catalyst mount portion 12.

The catalyst mount portion 12 includes, for example, a catalyst carrier and a catalyst coated thereon, and is connected to the downstream end portion of the internal combustion engine 11 (exhaust manifold 17) to purify toxic components such as hydrocarbon (HC), nitrogen oxide (NOx), and carbon monoxide (CO) contained in the exhaust gas discharged from the internal combustion engine 11.

The exhaust pipe 13 is provided for guiding the exhaust gas purified at the catalyst mount portion 12 to the muffler 14, and the upstream end portion thereof is connected to the catalyst mount portion 12, and the downstream end portion thereof is connected to the muffler 14.

The muffler 14 is provided to reduce the noise generated in the engine 16 (in particular, power stroke), and the upstream end portion thereof is connected to the downstream end portion of the exhaust pipe 13. The downstream end portion of the muffler 14 is connected to the upstream end portion of the outlet pipe 15.

The outlet pipe 15 is provided for releasing, into the air, the exhaust gas that was discharged from the engine 16, and was purified, with its noise reduced passing through the exhaust manifold 17, the catalyst mount portion 12, the exhaust pipe 13, and the muffler 14 sequentially. The upstream end portion of the outlet pipe 15 is connected to the downstream end portion of the muffler 14, and the downstream end portion of the outlet pipe 15 is open into the air.

The automobile 25 is equipped with, as shown by the dotted line in FIG. 2, the power-generating system 1.

The power-generating system 1 includes, as described above, a heat source 2, a first device 3, a second device 4, a temperature sensor 8, an electric field application device 9, and a control unit 10.

In the power-generating system 1, the engine 16 of the internal combustion engine 11 is used as the heat source 2, and as shown in the enlarged view and FIG. 3, in the box space 20 of each of the branch pipes 18, the first devices 3 are disposed.

The first device 3 is formed into a sheet, and in the box space 20, the plurality of first devices 3 are arranged in line with a space provided from each other, and are fixed by the second device 4 (or by a fixing member provided as necessary (not shown)), which are not shown.

In this manner, the both sides of the first device 3, i.e., the front face and the reverse face, and furthermore, the peripheral side faces are exposed to the air inside the box space 20 via the second device 4, which are not shown, so that they can be in contact with (exposed to) the exhaust gas.

The second device 4 includes, although not shown, two electrodes that are disposed to face each other with the first device 3 interposed therebetween, and lead wires to be connected to these electrodes.

The temperature sensor 8 is disposed, as shown in the enlarged view in FIG. 2, in the proximity of and the upstream of (flow direction of the exhaust gas) the plurality of first devices 3 in each of the branch pipes 18, and is disposed so as to be capable of detecting their temperature.

The number of the temperature sensor 8 is not limited, as long as the temperature of the plurality of first devices 3 (ref: FIG. 3) can be detected, and a single temperature sensor 8 or a plurality of temperature sensors 8 are provided as necessary.

The electric field application device 9 includes a plurality of (two per one box space) electrodes 22, and the electrodes 22 are disposed at the outer side faces of each of the box space 20 so as to face each other.

To be specific, the electrodes 22 are provided, so that a pair of the electrodes 22 are provided in every box space 20, and are connected in parallel by, for example, a branch lead wire.

Then, by applying a voltage to the electrodes 22 from the voltage application power source V, an electric field is induced between the electrodes 22, that is, in the box space 20, so that an electric field can be applied to the first device 3.

The control unit 10 is electrically connected to all of the temperature sensors 8 and the electric field application devices 9 at outside the box space 20, as shown in the broken line.

To be specific, the control unit 10 is connected in parallel by, for example, a branch lead wire, to each of the temperature sensors 8 provided in the box spaces 20, and is connected to the electric field application device 9.

As shown in FIG. 2, the power-generating system 1 is electrically connected, in sequence, to the booster 5, the alternating current/direct current converter 6, and the battery 7.

In such an automobile 25, the engine 16 is driven by repetitive up-down motion of pistons in cylinders, performing the intake stroke, the compression stroke, the power stroke, and the exhaust stroke in sequence, thereby increasing and decreasing the temperature thereof over time.

To be more specific, for example, in the two cylinders of the cylinder connected to the branch pipe 18a and the cylinder connected to the branch pipe 18c, the pistons work together to conduct the intake stroke, the compression stroke, the power stroke, and the exhaust stroke synchronously. This allows fuel combustion and output of motive power, allowing a high temperature exhaust gas to pass through inside of the branch pipe 18a and the branch pipe 18c in the exhaust stroke.

At this time, the heat of the engine 16 is conducted through the exhaust gas (heating medium); and the internal temperature of the branch pipe 18a and the branch pipe 18c increases in the exhaust stroke and decreases in other strokes (intake stroke, compression stroke, and power stroke), and therefore increases and decreases over time in accordance with the piston cycle, thus repeating a high-temperature state and a low-temperature state periodically.

On the other hand, at different timing from these two cylinders, in the two cylinders of the cylinder connected to the branch pipe 18b and the cylinder connected to the branch pipe 18d, pistons work together to conduct the intake stroke, the compression stroke, the power stroke, and the exhaust stroke synchronously. This allows fuel combustion and output of motive power at different timing from the branch pipe 18a and the branch pipe 18c, allowing a high temperature exhaust gas to pass through inside of the branch pipe 18b and the branch pipe 18d in the exhaust stroke.

At this time, the heat of the engine 16 is conducted through the exhaust gas (heating medium), the internal temperature of the branch pipe 18b and the branch pipe 18d increases in the exhaust stroke, and decreases in other strokes (intake stroke, compression stroke, and power stroke), and therefore increases and decreases over time in accordance with the piston cycle, thus repeating a high-temperature state and a low-temperature state periodically.

The periodic temperature change occurs at the same period, but at a different phase from the periodic temperature change of the branch pipe 18a and the branch pipe 18c.

In the power-generating system 1, as described above, a sheet first device 3 is disposed inside each of the branch pipes 18 (in the box spaces 20).

Thus, when the exhaust gas discharged from the engine 16 (heat source 2) is introduced into the branch pipes 18 and the box space 20 is filled with the exhaust gas, in the box space 20, the both sides of the front face and the reverse face (furthermore, peripheral side faces) of the first device 3 make contact with (is exposed to) the exhaust gas (heating medium) (via the second device 4), and is heated and/or cooled.

That is, both sides of the front face and the reverse face of the first device 3 are heated and/or cooled by the temperature change over time of the engine 16 (heat source 2), and the heating medium that conducts heat of the engine 16.

In this manner, a periodic high-temperature state or low-temperature state can be caused in the first device 3, and polarization can be caused in the first device 3 in accordance with the effects (e.g., piezoelectric effect, pyroelectric effect, etc.) of the element (e.g., piezoelectric element, pyroelectric element, etc.).

Thus, in the power-generating system 1, a net generating power can be taken out from the first devices 3 via the second devices 4 as a periodically changing waveform (e.g., alternating current, pulsating current, etc.).

Meanwhile, as described above, in such a power-generating system 1, the temperature of the first device 3 may exceed its Curie temperature depending on the temperature conditions. Then, when the first device 3 is used under the environment of the Curie temperature of the first device 3 or higher, the first device 3 may be damaged, which may cause reduction in power generation performance, or power generation may not be achieved.

Thus, as described above, in the power-generating system 1, the temperature sensor 8 detects the temperature of the first device 3, and when the detected temperature is the Curie temperature of the first device 3 or higher, the control unit 10 activates the electric field application device 9 with the above conditions, and an electric field is applied to the first device 3.

In this manner, damages to the first device 3 can be suppressed even if the first device 3 is exposed to an environment in which the temperature is higher than the Curie temperature.

Furthermore, in the power-generating system 1, the temperature of the branch pipe 18a and the branch pipe 18c, and the temperature of the branch pipe 18b and the branch pipe 18d change at the same period, but at a different phase periodically, and therefore a net generating power can be taken out continuously as a periodically changing waveform (e.g., alternating current, pulsating current, etc.).

Then, the exhaust gas passes through the branch pipes 18, and then is supplied to the collection pipe 19. After the collection, the exhaust gas is supplied to the catalyst mount portion 12, and is purified by the catalyst provided in the catalyst mount portion 12. Thereafter, the exhaust gas is supplied to the exhaust pipe 13, and after the noise is reduced in the muffler 14, the exhaust gas is discharged outside through the outlet pipe 15.

At this time, the exhaust gas that passes through the branch pipes 18 is collected in the collection pipe 19, and therefore the temperature of the exhaust gas that passes through the collection pipe 19, the catalyst mount portion 12, the exhaust pipe 13, the muffler 14, and the outlet pipe 15 in sequence is smoothed.

Thus, the temperature of the collection pipe 19, the catalyst mount portion 12, the exhaust pipe 13, the muffler 14, and the outlet pipe 15, which allow the exhaust gas with its temperature smoothed to pass through, usually does not go up and down over time, keeping a substantially constant temperature.

Therefore, when the collection pipe 19, the catalyst mount portion 12, the exhaust pipe 13, the muffler 14, or the outlet pipe 15 is used as the heat source 2, and the above-described first devices 3 are disposed at the surrounding or inside thereof, the voltage of the net generating power taken out from the first device 3 is small, and also is constant (direct current voltage).

Thus, in such a method, the voltage of the obtained net generating power cannot be increased with a simple structure, which is disadvantageous in that storage of electricity is inefficient.

On the other hand, as described above, when the first device 3 is disposed at the inner space of the branch pipes 18, a periodic high-temperature state or low-temperature state is allowed in the first device 3 based on the temperature change over time of the heat source 2, and periodic polarization can be caused in the first device 3 in accordance with the effects (e.g., piezoelectric effect, pyroelectric effect, etc.) of the device (e.g., piezoelectric element, pyroelectric element, etc.).

Thus, in the power-generating system 1, a net generating power can be taken out from the first devices 3 via the second devices 4 as a periodically changing waveform (e.g., alternating current, pulsating current, etc.).

Thereafter, in this method, for example, as shown by the dotted line in FIG. 2, the voltage of the net generating power obtained as described above is increased in the booster 5 connected to the second device 4 under the state of a periodically changing waveform (e.g., alternating current, pulsating current, etc.), and then after the net generating power with its voltage boosted is converted to a direct current voltage in an alternating current/direct current converter 6, the net generating power is stored in the battery 7. The net generating power stored in the battery 7 is used suitably as a motive power for the automobile 25, or for various electrical accessories mounted in the automobile 25.

In such a power-generating system 1, the heat source 2 having a temporal temperature variation is used, and therefore a changing voltage (e.g., alternating current voltage) can be taken out, and as a result, compared with the case where a constant voltage (direct current voltage) is taken out and converted with a DC-DC converter, excellently efficient boosting of voltage and storage of electricity can be achieved.

Particularly, with such a power-generating system 1, improvement in power generation efficiency can be achieved.

That is, in such a power-generating system 1, the temperature sensor 8 detects the temperature of the first device 3, and when the detected temperature is the Curie temperature of the first device 3 or higher, the control unit 10 activates the electric field application device 9, and an electric field is applied to the first device 3.

Thus, damages to the first device 3 can be suppressed even if the first device 3 is exposed to an environment in which the temperature is higher than the Curie temperature, and reduction in power generation performance of the power-generating system 1 can be suppressed, and power generation failure can be suppressed. Thus, electricity can be generated with excellent efficiency even under a high-temperature environment.

<Second Embodiment>

In the following, a second embodiment outside the scope of the present invention is described.

Detailed description for the same member and principle as in the first embodiment above is omitted.

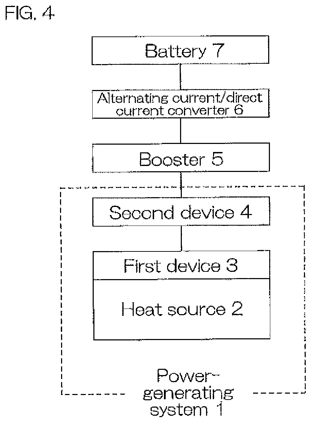

FIG. 4 is a schematic diagram illustrating the configuration of the second embodiment of the power-generating system.

In FIG. 4, a power-generating system 1 includes a heat source 2 having a temporal temperature variation; a first device 3 that undergoes polarization due to a temperature change of the heat source 2; and a second device 4 that takes out a net generating power from the first device 3.

The heat source 2 is not particularly limited, as long as the heat source has a temporal temperature variation, and examples thereof include various energy-using devices such as internal combustion engines, and luminous devices.

The internal combustion engine is, for example, a device that outputs motive power for vehicles. For example, a single cylinder or a multicylinder type is used, and in the single cylinder or multicylinder, a multi-stroke cycle (e.g., two-stroke cycle, four-stroke cycle, and six-stroke cycle, etc.) is used.

In such an internal combustion engine, pistons repeatedly move up and down in the cylinders, and such up-down moves of the pistons allow, for example, in the four-stroke cycle system, performance of an intake stroke, a compression stroke, a power stroke, and an exhaust stroke sequentially, and combustion of fuel, to output motive power.

In such an internal combustion engine, in the exhaust stroke, a high temperature exhaust gas is discharged via the exhaust gas pipe. At that time, the exhaust gas pipe receives the heat energy of the exhaust gas, increasing the temperature.

Meanwhile, in other strokes (strokes excluding the exhaust stroke), the exhaust gas amount in the exhaust gas pipe decreases, and therefore the heat energy received by the exhaust gas pipe decreases. As a result, the temperature of the exhaust gas pipe decreases.

Thus, the temperature of the internal combustion engine increases in the exhaust stroke, decreases in the intake stroke, compression stroke, and power stroke: that is, the temporal temperature variation is produced.

In particular, the above-described strokes are repeated periodically and sequentially in accordance with the piston cycle, and therefore the temperature of the exhaust gas pipes of the cylinders of the internal combustion engine changes periodically in accordance with the cycle of the repetition of the above-described strokes, to be more specific, a high-temperature state and a low-temperature state are repeated periodically.

The temperature of the luminous device increases when the luminous device is turned on (emission), for example, by heat energy of light such as infrared radiation and visible light, while when the luminous device is turned off, its temperature decreases. Thus, the temporal temperature variation of the luminous devices is produced when turned on (emission) or off.

In particular, for example, when the luminous device is a luminous device that repeats turning on and off of light over time intermittently (blinking (switching) luminous device), the temperature of the luminous device changes periodically by heat energy of light at the time when turned on (emission), to be more specific, a high-temperature state and a low-temperature state are repeated periodically.

Examples of the heat source 2 further include a plurality of heat sources, and a temperature change can also be caused by switching between the plurality of heat sources.

To be more specific, for example, in an embodiment, the heat source includes two heat sources, i.e., a low temperature heat source (coolant, etc.) and a high temperature heat source (e.g., heating material, etc.) having a temperature higher than the low temperature heat source; and the low temperature heat source and the high temperature heat source are switched back and forth alternately over time.

In this manner, the temperature of the heat source can be increased or decreased over time, and in particular, by repeating the switching back and forth between the low temperature heat source and the high temperature heat source periodically, the periodic temperature change can be achieved.

The heat source 2 including a plurality of switchable heat sources is not particularly limited, and examples thereof include a high temperature air furnace (e.g., a high-temperature gas generator described in WO96-05474) including a combustion low temperature air supplier, a regenerator heat exchanger, a high temperature gas exhauster, and a supply/exhaust switch valve; and a seawater exchange system (hydrogen storage alloy actuator seawater exchange system) using a high temperature heat source, a low temperature heat source, and a hydrogen storage alloy.

As the heat source 2, the above-described heat sources maybe used singly or in combination of two or more.

As the heat source 2, preferably, a heat source that undergoes a periodic temperature change over time is used.

As the heat source 2, preferably, an internal combustion engine is used.

The first device 3 is a device that undergoes polarization in accordance with the temperature change of the heat source 2.

The polarization here is defined as the following: a phenomenon of electromotive force occurrence in a material, including, for example, a phenomenon of occurrence of a potential difference by dielectric polarization due to displacement of plus and minus ions based on the deformation of a crystal, such as the piezoelectric effect; and/or a phenomenon of occurrence of a potential difference by changes in the dielectric constant due to a temperature change, such as the pyroelectric effect; and/or a phenomenon of occurrence of a potential difference by partial electric charge due to a temperature change or a temperature gradient, such as the Seebeck effect.

Examples of the first device 3 include, to be more specific, a device that undergoes polarization by the piezoelectric effect, a device that undergoes polarization by the pyroelectric effect, and a device that undergoes polarization by the Seebeck effect.

In the piezoelectric effect (phenomenon), polarization is caused when a pressure or a deformation is applied in accordance with the degree of the pressure or the deformation.

As the first device 3 that undergoes polarization by the piezoelectric effect, a composite element obtained by using a known piezoelectric element material as the matrix material (hereinafter referred to as piezo-based composite element) which is to be described in detail later, may be used.

When a piezo-based composite element (described later) is used as the first device 3, the piezo-based composite element (described later) is disposed, for example, so that the piezo-based composite element is brought in the proximity of the heat source 2, or into contact with the heat source 2 with the electrode to be described later interposed therebetween while the surrounding thereof is fixed by a fixing member to suppress the volume expansion thereof. The fixing member is not particularly limited, and for example, the second device 4 (e.g., electrode, etc.) to be described later may also be used.

In this case, the piezo-based composite element (described later) is heated or cooled by the temperature change over time of the heat source 2, which allows expansion or shrinkage thereof.

In such a case, the volume expansion of the piezo-based composite element (described later) is suppressed by the fixing member, and therefore the piezo-based composite element (described later) is pressed by the fixing member, which allows polarization to occur by the piezoelectric effect or phase transformation near the Curie temperature. In this manner, although to be described later, a net generating power is taken out from the piezo-based composite element (described later) via the second device 4.

In such a piezo-based composite element (described later), usually, a heated state or a cooled state is kept, and when its temperature becomes constant (that is, the volume is constant), the polarization is neutralized, and by cooling or heating thereafter, the piezoelectric element undergoes polarization again.

Thus, as described above, when the temperature of the heat source 2 changes periodically, and a high-temperature state and a low-temperature state are periodically repeated, the piezo-based composite element (described later) is heated and cooled repeatedly and periodically, and therefore polarization and neutralization of the piezo-based composite element (described later) are periodically repeated.

As a result, a net generating power can be taken out as a periodically changing waveform (e.g., alternating current, pulsating current, etc.) by the second device 4 to be described later.

The pyroelectric effect is, for example, the effects (phenomenon) such as the following: when an insulator (dielectric) is heated or cooled, the insulator undergoes polarization in accordance with the temperature change. The pyroelectric effect includes a first effect and a second effect.

In the first effect, at the time of heating or cooling of the insulator, spontaneous polarization occurs by the temperature change, and an electric charge is generated on the insulator surface.

In the second effect, at the time of heating or cooling of the insulator, pressure deflection is caused in the crystal structure by the temperature change, and the pressure or the deformation on the crystal structure causes piezoelectric polarization (piezoelectric effect).

As a device that undergoes polarization by the pyroelectric effect, a composite element obtained by using a known pyroelectric element material as the matrix material (hereinafter referred to as pyroelectric-based composite element) which is to be described in detail later, may be used.

When a pyroelectric-based composite element (described later) is used as the first device 3, the pyroelectric-based composite element (described later) is disposed, for example, in the proximity of the heat source 2, or so as to be in contact with the heat source 2 with an electrode to be described later interposed therebetween.

In such a case, the pyroelectric-based composite element (described later) is heated or cooled by temporal temperature variation of the heat source 2, and undergoes polarization by its pyroelectric effect (including the first effect and second effect). In this manner, although to be described later, a net generating power is taken out from the pyroelectric-based composite element (described later) via the second device 4.

In such a pyroelectric-based composite element (described later), usually, a heated state or a cooled state is kept, and when its temperature becomes constant, the polarization is neutralized, and by cooling or heating thereafter, the pyroelectric-based composite element (described later) undergoes polarization again.

Thus, as described above, when the temperature of the heat source 2 changes periodically, and a high-temperature state and a low-temperature state are periodically repeated, the pyroelectric-based composite element (described later) is heated and cooled periodically and repeatedly, and therefore the polarization and neutralization of the pyroelectric-based composite element (described later) are periodically repeated.

As a result, a net generating power can be taken out as a periodically changing waveform (e.g., alternating current, pulsating current, etc.) by the second device 4 to be described later.

The Seebeck effect is, for example, the effect (phenomenon) such as the following: when a temperature difference is generated at both ends of a metal or a semiconductor, an electromotive force is generated in the metal or the semiconductor in accordance with the temperature difference.

As a device that undergoes polarization by the Seebeck effect, a composite element obtained by using a known thermoelectric element material as the matrix material (hereinafter referred to as thermoelectric-based composite element) which is to be described in detail later, may be used.

When a thermoelectric-based composite element (described later) is used as the first device 3, the thermoelectric-based composite element (described later) is disposed, for example, so that one end portion thereof is brought in the proximity of the heat source 2, or into contact with the heat source 2 with the electrode to be described later interposed therebetween, and the other end portion thereof is distant from the heat source 2.

In this case, only one end portion of the thermoelectric-based composite element (described later) is heated or cooled by the temperature change over time of the heat source 2, and a temperature difference is caused between the both ends (between one end portion and the other end portion thereof) of the thermoelectric-based composite element (described later). At this time, an electromotive force is generated in the thermoelectric-based composite element (described later) by the Seebeck effect. In this manner, although to be described later, a net generating power is taken out from the thermoelectric-based composite element (described later) via the second device 4.

In such a thermoelectric-based composite element (described later), when the temperature difference between the both ends is large, the electromotive force is high, which allows for obtainment of a high net generating power. On the other hand, when the temperature difference is small, the electromotive force is small, which decreases the net generating power to be taken out.

Thus, as described above, when the temperature of the heat source 2 changes periodically, and a high-temperature state and a low-temperature state are periodically repeated, the temperature of the one end portion of the thermoelectric-based composite element (described later) increases or decreases repeatedly and periodically, and therefore the degree of the electromotive force increases or decreases periodically in accordance with the temperature change.

As a result, a net generating power can be taken out as a periodically changing waveform, (e.g., alternating current, pulsating current, etc.) by the second device 4 to be described later.

These first devices 3 may be used singly or in combination of two or more.

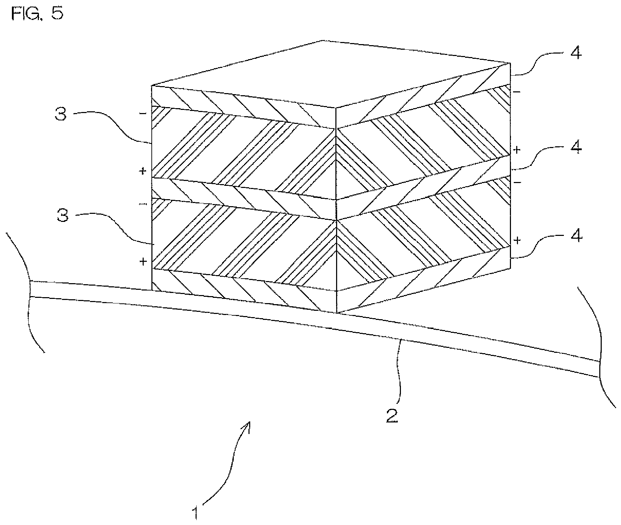

FIG. 5 is a schematic diagram illustrating the configuration of an embodiment of the first device shown in FIG. 4.

The above-described first device 3 can also be used, as shown in FIG. 5, for example, in a stack.

In such a case, a second device 4 (for example, electrode, lead wire, etc.) to be described later is interposed between a plurality of first devices 3 (preferably pyroelectric-based composite element (described later)), and in this fashion, the first devices 3 are connected electrically to be in series at the time of polarization.

Then, the thus obtained stack of the first devices 3 is disposed, as shown in FIG. 4, so as to be in contact with or in the proximity of the heat source 2, and the stacked first devices 3 are simultaneously heated or cooled.

Polarization is caused simultaneously in the plurality of first devices 3 and electrical connection in series is allowed in this manner, and as a result, compared with the case where the first device 3 is used singly (as a single layer), a high net generating power can be taken out.

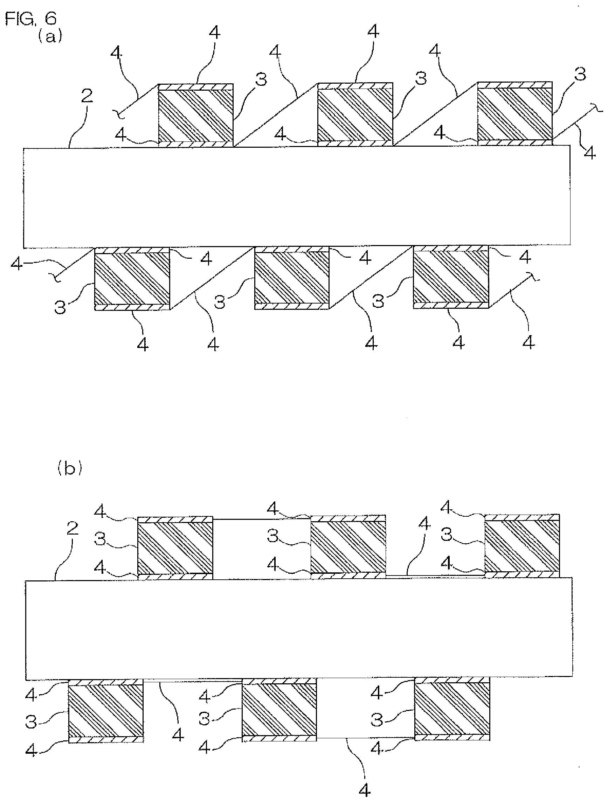

FIG. 6 is a schematic diagram illustrating the configuration of another embodiment of the first device shown in FIG. 4.

The above-described first device 3 can also be used, as shown in FIG. 6, for example, by arranging the first devices 3 in line on the same plane.

In this case, the second devices 4 (e.g., electrode, lead wire, etc.) to be described later are provided between the plurality of first devices 3, thus connecting the first devices 3 electrically in series at the time of polarization.

Then, the plurality of first devices 3 thus arranged in line are disposed, as shown in FIG. 4, so as to be in contact with or in the proximity of the heat source 2, and all of the first devices 3 arranged in line are heated or cooled simultaneously.

Polarization is caused simultaneously in the plurality of first devices 3 and electrical connection in series is allowed in this manner, and as a result, compared with the case where the first device 3 is used singly, a high net generating power can be taken out.

At that time, for example, when the first device 3 is a pyroelectric-based composite element (described later), or when only a thermoelectric-based composite element (described later) composed of p-type semiconductor or a thermoelectric-based composite element (described later) composed of n-type semiconductor is used, in the first devices 3, polarization occurs so that one side that is in contact with or in the proximity of the heat source 2 is all positive electrodes or negative electrodes, and the other side that is distant from the heat source 2 is all negative electrodes or positive electrodes (ref: FIG. 6 (a)).

Therefore, in such a case, the side making contact with or in the proximity of the heat source 2 in one first device 3 is electrically connected with the side distant from the heat source 2 in another first device 3.

On the other hand, when a thermoelectric-based composite element (described later) composed of p-type semiconductor, and a thermoelectric-based composite element (described later) composed of n-type semiconductor are used as the first device 3, and these are disposed alternately, polarization occurs oppositely in the thermoelectric-based composite element (described later) composed of p-type semiconductor and the thermoelectric-based composite element (described later) composed of n-type semiconductor, and therefore at one side of the first devices 3 that is brought into contact with or in the proximity of the heat source 2, a positive electrode and a negative electrode are alternately arranged in line.

Thus, in such a case, the side making contact with or in the proximity of the heat source 2 in one first device 3 is electrically connected with the side making contact with or in the proximity of the heat source 2 in another first device 3, and the side distant from the heat source 2 in one first device 3 is electrically connected with the side distant from the heat source 2 of another first device 3 (ref: FIG. 6 (b)).

In FIG. 4, the second device 4 is provided so as to take out a net generating power from the first device 3.

Such a second device 4 is not particularly limited, and includes, for example, two electrodes (e.g., copper electrode, silver electrode, etc.) that are disposed to face each other with the above-described first device 3 sandwiched therebetween, and lead wires to be connected to these electrodes; and is electrically connected to the first device 3.

In a power-generating system 1 shown in FIG. 4, the second device 4 is electrically connected to, in sequence, a booster 5, an alternating current/direct current converter (AC-DC converter) 6, and a battery 7.

To generate electricity by such a power-generating system 1, for example, first, the temperature of the heat source 2 is increased or decreased over time; preferably, the temperature is changed periodically to cause polarization preferably periodically in the above-described first device 3 in accordance with the temperature change. Thereafter, through the second device 4, a net generating power is taken out as a periodically changing waveform (e.g., alternating current, pulsating current, etc.) in accordance with the periodical polarization of the first device 3.

In such a power-generating system 1, the temperature of the heat source 2 during the high-temperature state is, for example, 500 to 1200°C, preferably 700 to 900°C; temperature of the heat source 2 during the low-temperature state is below the above-described high-temperature state temperature, to be more specific, for example, 200 to 800°C, preferably 200 to 500°C; and the temperature difference between the high-temperature state and the low-temperature state is, for example, 10 to 600°C, preferably 20 to 500°C.

The repetition cycle of the high-temperature state and low-temperature state is, for example, 10 to 400 cycles/sec, preferably 30 to 100 cycles/sec.

The net generating power thus taken out from the power-generating system 1 is boosted in the booster 5 connected to the second device 4, as in a state of a periodically changing waveform (e.g., alternating current, pulsating current, etc.). For the booster 5, a booster that is capable of boosting the alternating current voltage with excellent efficiency with a simple structure using, for example, a coil, condenser, etc is used.

Then, the net generating power with its voltage boosted by the booster 5 is converted to a direct current voltage in the alternating current/direct current converter 6, and thereafter, stored in the battery 7.

In such a power-generating system 1, the heat source 2 having a temporal temperature variation is used, and therefore a changing voltage (e.g., alternating current voltage) can be taken out, and as a result, compared with the case where a constant voltage (direct current voltage) is taken out and converted with a DC-DC converter, excellently efficient boosting of voltage and storage of electricity can be achieved.

Furthermore, when the heat source 2 is a heat source that periodically undergoes temperature change, the net generating power can be taken out as a periodically changing waveform, and as a result, more excellently efficient boosting of voltage and storage of electricity can be achieved.

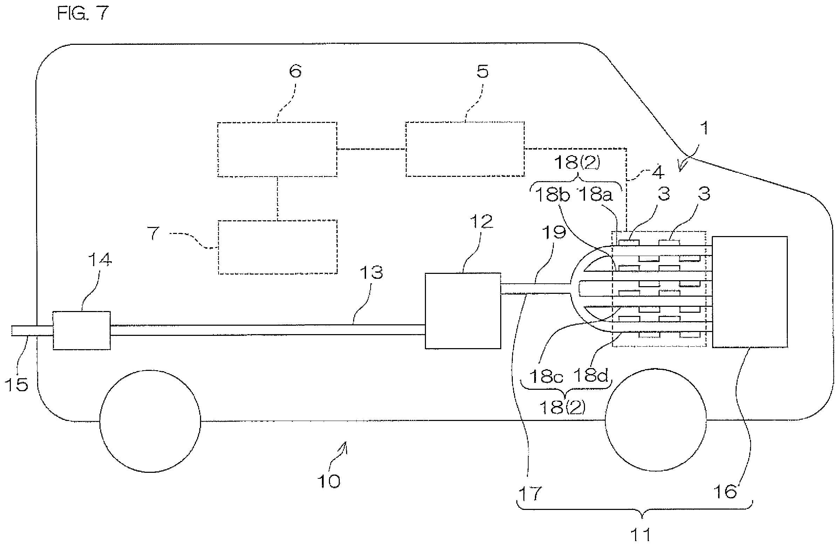

FIG. 7 is a schematic diagram illustrating the configuration of the second embodiment of the power-generating system on board.

In FIG. 7, an automobile 10 includes an internal combustion engine 11, a catalyst mount portion 12, an exhaust pipe 13, a muffler 14, and an outlet pipe 15.

The internal combustion engine 11 includes an engine 16, and an exhaust manifold 17.

The engine 16 is a four cylinder, four-stroke cycle engine, and upstream end portions of branch pipes 18 (described later) of the exhaust manifold 17 are connected to the cylinders.

The exhaust manifold 17 is provided for collecting the exhaust gas discharged from the cylinders of the engine 16; and includes a plurality of (four) branch pipes 18 (when these have to be distinguished, these are referred to as, from the top in FIG. 7, a branch pipe 18a, a branch pipe 18b, a branch pipe 18c, and a branch pipe 18d.) connected to the cylinders of the engine 16, and a collection pipe 19 that integrates the branch pipes 18 at a downstream side of the branch pipes 18.

In such an exhaust manifold 17, the upstream end portions of the branch pipes 18 are connected to the cylinders of the engine 16, and the downstream end portions of the branch pipes 18 are connected to the upstream end portion of the collection pipe 19. The downstream end portion of the collection pipe 19 is connected to the upstream end portion of the catalyst mount portion 12.

The catalyst mount portion 12 includes, for example, a catalyst carrier and a catalyst coated thereon, and is connected to the downstream end portion of the internal combustion engine 11 (exhaust manifold 17) to purify toxic components such as hydrocarbon (HC), nitrogen oxide (NOx), and carbon monoxide (CO) contained in the exhaust gas discharged from the internal combustion engine 11.

The exhaust pipe 13 is provided for guiding the exhaust gas purified at the catalyst mount portion 12 to the muffler 14, and the upstream end portion thereof is connected to the catalyst mount portion 12, and the downstream end portion thereof is connected to the muffler 14.

The muffler 14 is provided to reduce the noise generated in the engine 16 (in particular, power stroke), and the upstream end portion thereof is connected to the downstream end portion of the exhaust pipe 13. The downstream end portion of the muffler 14 is connected to the upstream end portion of the outlet pipe 15.

The outlet pipe 15 is provided for releasing, into the air, the exhaust gas that was discharged from the engine 16, and was purified, with its noise reduced passing through the exhaust manifold 17, the catalyst mount portion 12, the exhaust pipe 13, and the muffler 14 sequentially. The upstream end portion of the outlet pipe 15 is connected to the downstream end portion of the muffler 14, and the downstream end portion of the outlet pipe 15 is open into the air.

The automobile 10 is equipped with, as shown by the dotted line in FIG. 7, the power-generating system 1.

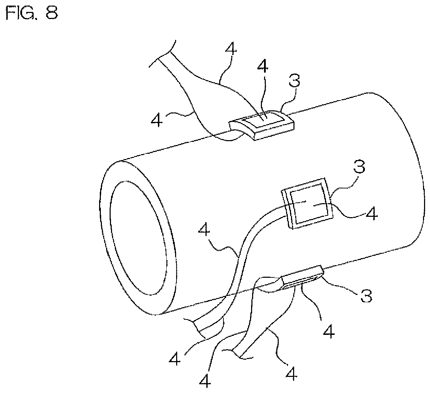

FIG. 8 is an enlarged view of a relevant part of the power-generating system shown in FIG. 7.

In FIG. 8, the power-generating system 1 includes, as described above, the heat source 2, the first device 3, and the second device 4.

In the power-generating system 1, the branch pipe 18 of the exhaust manifold 17 in the internal combustion engine 11 is used as the heat source 2, and the first device 3 is disposed around the branch pipe 18.

The first device 3 is a composite element composed of a matrix that is capable of polarization, and a dispersion material having a specific heat capacity that is lower than the specific heat capacity of the matrix; and is formed by dispersing the dispersion material in the matrix.

Such a composite element can be obtained, for example, by mixing a matrix material powder for forming the matrix and a dispersion material powder and dispersing the dispersion material in the matrix material, thereby producing their mixture.

Examples of the matrix material include known pyroelectric element materials (e.g., $BaTiO_3$, $CaTiO_3$, $(CaBi)TiO_3$, $BaNd_2Ti_5O_{14}$, $BaSm_2Ti_4O_{12}$, lead zirconate titanate (PZT: $Pb (Zr,Ti) O_3$), etc.), known thermoelectric

element materials (e.g., Bi-Te-based thermoelectric element (e.g., $Bi_2Te_3$, $Bi_2Te_3/Sb_2Te_3$, etc.)), PbTe, $AgSbTe_2/GeTe$, $NaCo_2O_4$, $CaCoO_3$, $SrTiO_3/SrTiO_3$: Nb, SiGe, $\beta$-$FeSi_2$, $Ba_8S_{46}$, $Mg_2Si$, $MnSi_{1.73}$, ZnSb, $Zn_4Sb_3$, $CeFe_3CoSb_{12}$, $LaFe_3CoSb_{12}$, $SrTiO_3/SrTiO_3$: $Nb/SrTiO_3$, Si nanowire array, $NaCo_2O_4$, $(Ce_{1-x}La_x)Ni_2$, $(Ce_{1-x}La_x)In_3$, $CeInCu_2$, $NaV_2O_5$, $V_2O_5$, etc.), known piezoelectric element materials (e.g., crystal ($SiO_2$ aluminum oxide ($Al_2O_3$), zinc oxide (ZnO), Rochelle salt (potassium sodium tartrate)($KNaC_4H_4O_6$), lead zirconate titanate (PZT: $Pb (Zr,Ti)O_3$), lithium niobate ($LiNbO_3$), lithium tantalate ($LiTaO_3$), lithium tetraborate ($Li_2B_4O_7$), langasite ($La_3Ga_5SiO_{14}$), aluminum nitride (AlN), tourmaline, and polyvinylidene fluoride (PVDF), etc.).

These matrix materials may be used singly or in combination of two or more.

When the pyroelectric element material is used as the matrix material, a composite element (pyroelectric-based composite element) that undergoes polarization by pyroelectric effect can be obtained; when the thermoelectric element material is used, a composite element (thermoelectric-based composite element) that undergoes polarization by Seebeck effect can be obtained; and furthermore, when the piezoelectric element material is used, a composite element (piezo-based composite element) that undergoes polarization by piezoelectric effect can be obtained.

The matrix material has an average particle size (measurement method: scanning electron microscope) of, for example, 0.1 to 100 $\mu$m, preferably 0.5 to 10 $\mu$m,

This is because when the matrix material has a particle size of below the above-described range, the fraction of the grain boundary increases and the dielectric constant becomes largely dependent on the temperature, the temperature range that can be used becomes narrow, and on the other hand, when the matrix material has a particle size of more than the above-described range, the fracture origin size of the matrix material becomes large and causes the strength of the material to decrease.

The matrix material, and also the matrix formed from the matrix material has a specific heat capacity of, for example, 0.01 to 10J/g·K, preferably 0.1 to 5J/g·K.

This is because when the matrix material, and also the matrix made from the matrix material has a specific heat capacity that is too low, heat from the heat source immediately raise the temperature of the entire material, the thermal stress becomes significantly high at the interface of, for example, the material and the electrode, which may cause the electrode to detach, on the other hand, when the specific heat capacity is too high, the temperature change inside the material becomes less responsive to the heat change from outside, and therefore the power generation using temperature change, i.e., a purpose in the present invention, becomes difficult.

The dispersion material is not particularly limited, as long as the dispersion material has a specific heat capacity that is lower than the specific heat capacity of the matrix material and of the matrix formed from the matrix material, and for example, elements of noble metals such as Ru (ruthenium), Rh (rhodium), Pd (palladium), Ag (silver), Os (osmium), Ir (iridium), and Pt (platinum); elements of transition metals such as Cr (chromium), Mn (manganese), Fe (iron), Co (cobalt), Ni (nickel), Cu (copper), and Zn (zinc); and oxide, carbonate, nitrate, sulfate, diketone metal complex, and hydride complex of these may be used.

These dispersion materials may be used singly or in combination of two or more.

The dispersion material is preferably a dispersion material that is in the state of reduced state at 200 to 1000°C, more preferably at 200 to 500°C. Examples of such dispersion materials include, to be specific, oxides, carbonates, nitrates, sulfates, diketone metal complexes, hydride complexes of, for example, Rh (rhodium), Pd (palladium), Ag (silver), Pt (platinum), Cr (chromium), Ni (nickel), and Cu (copper).

Use of such a dispersion material allows for decomposition of the dispersion material by reduction at the time of sintering (described later) of the matrix, and therefore a fine dispersed phase can be formed.

The dispersion material has an average particle size (measurement method: scanning electron microscope) of, for example, 0.002 to 10 mm, preferably 0.01 to 3 nm.

This is because when the dispersed phase becomes too small, the sintering (described later) of the matrix may be hindered, and when the dispersed phase becomes too large, separation from the matrix easily occur, decreasing the effects of electric conduction, thermal conduction, and mechanical characteristics by forming composites.

The dispersion material has a specific heat capacity of, in view of changing the temperature inside the composite element in accordance with the heat source given from outside, lower than the specific heat capacity of the above-described matrix material, and the matrix formed from the matrix material, to be specific, for example, 0.01 to 10J/g·K, preferably 0.1 to 5J/g·K.

The mixing ratio of the dispersion material to the matrix material is, for example, 0.01 to 50 parts by mass, preferably 0.1 to 40 parts by mass of the dispersion material relative to 100 parts by mass of the matrix material.

In this method, the matrix material and the dispersion material are mixed by, for example, a known mixing method such as dry mixing, and wet blending, and as necessary, molded by using a mold (e.g., press molding), thereby producing a composite element in which the dispersion material is dispersed in the matrix.

Furthermore, in this method, as necessary, the composite element can be sintered.

The sintering conditions are, for example, as follows: under an inert gas atmosphere, the heating temperature is, for example, 500 to 1800°C, preferably 800 to 1500°C, and the heating time of, for example, 0.1 to 24 hours, preferably 0.5 to 4 hours. These conditions are suitably optimized so as to improve most the density of the composite element depending the volume and shape of the sample.

When such a first device 3 is used, to be specific, a first device 3 composed of a matrix that is capable of polarization, and a dispersion material having a specific heat capacity that is lower than the specific heat capacity of the matrix, compared with the case where a device that is capable of polarization is simply used as the first device 3, electricity can be generated with excellent efficiency.

Furthermore, when the first device 3 is a pyroelectric-based composite element and/or a piezo-based composite element (insulator (dielectric)), the relative dielectric constant is, for example, 1 or higher, preferably 100 or higher, more preferably 2000 or higher.

In such a power-generating system 1, higher the relative dielectric constant of the first device 3 (insulator (dielectric)) is, the higher the energy conversion efficiency is, which allows for obtainment of a net generating power at high voltage. However, when the relative dielectric constant of the first device 3 is below the above-described lower limit, the energy conversion efficiency is low, and the voltage of the obtained net generating power may be low.

In the first device 3 (insulator (dielectric)), polarization occurs by the temperature change of the heat source 2, and the polarization may be any of electronic polarization, ionic polarization, and orientation polarization.

For example, it has been expected that with those materials in which polarization occurs by orientation polarization (e.g., liquid crystal material, etc.), improvement in power generation efficiency can be achieved by changing its molecule structure.

When the first device 3 is a thermoelectric-based composite element, its performance is represented, for example, by the following formula (1).

$$ZT = S^2\sigma T/\kappa \qquad (1)$$

(where Z represents figure of merit, T represents the absolute temperature, S represents the Seebeck coefficient, σ represents electric conductivity, and κ represents thermal conductivity.)

In the first device 3 (thermoelectric-based composite element), the ZT value (dimensionless figure of merit) is, for example, 0.3 or higher.

When the ZT value (dimensionless figure of merit) is below the above-described lower limit, the energy conversion efficiency is low, and the voltage of the obtained net generating power may be low.

Furthermore, because the thermoelectric-based composite element usually generates electricity based on the temperature difference inside the material, the lower the thermal conductivity of the thermoelectric element is, the higher the energy conversion efficiency is. However, in this power-generating system 1, the temperature difference at the both ends of the first device 3 (thermoelectric-based composite element) is not necessary, and therefore the thermal conductivity of the first device 3 (thermoelectric-based composite element) is not particularly limited.

The second device 4 includes two electrodes that are disposed to face each other with the first device 3 sandwiched therebetween, and lead wires connected to these electrodes. The electrode and the lead wire that are disposed at one side surface of the first device 3 are disposed so as to be interposed between the first device 3 and the branch pipe 18 (heat source 2), and the electrode and the lead wire that are disposed at the other side surface of the first device 3 are exposed without making contact with the branch pipe 18 (heat source 2).

As shown in FIG. 7, the power-generating system 1 is electrically connected, in sequence, to the booster 5, the alternating current/direct current converter 6, and the battery 7.

In such an automobile 10, the engine 16 is driven by repetitive up-down motion of pistons in cylinders, performing the intake stroke, the compression stroke, the power stroke, and the exhaust stroke in sequence.

To be more specific, for example, in the two cylinders of the cylinder connected to the branch pipe 18a and the cylinder connected to the branch pipe 18c, the pistons work together to conduct the intake stroke, the compression stroke, the power stroke, and the exhaust stroke synchronously. This allows fuel combustion and output of motive power, allowing a high temperature exhaust gas to pass through inside of the branch pipe 18a and the branch pipe 18c in the exhaust stroke.

At this time, the temperature of the branch pipe 18a and the branch pipe 18c increases in the exhaust stroke, and decreases in other strokes (intake stroke, compression stroke, and power stroke), and therefore increases and decreases over time in accordance with the piston cycle, thus repeating a high-temperature state and a low-temperature state periodically.

On the other hand, at different timing from these two cylinders, in the two cylinders of the cylinder connected to the branch pipe 18b and the cylinder connected to the branch pipe 18d, pistons work together to conduct the intake stroke, the compression stroke, the power stroke, and the exhaust stroke synchronously. This allows fuel combustion and output of motive power at different timing from the branch pipe 18a and the branch pipe 18c, allowing a high temperature exhaust gas to pass through inside of the branch pipe 18b and the branch pipe 18d in the exhaust stroke.

At this time, the temperature of the branch pipe 18b and the branch pipe 18d increases in the exhaust stroke, and decreases in other strokes (intake stroke, compression stroke, and power stroke), and therefore increases and decreases over time in accordance with the piston cycle, thus repeating a high-temperature state and a low-temperature state periodically.

The periodic temperature change occurs at the same period, but at a different phase from the periodic temperature change of the branch pipe 18a and the branch pipe 18c.

In the power-generating system 1, the first device 3 is disposed at every branch pipe 18 (heat source 2).

Thus, a periodic high-temperature state or low-temperature state can be caused in the first device 3 based on the temperature change over time of the branch pipes 18 (heat source 2), and polarization can be caused in the first device 3 in accordance with the effects (e.g., piezoelectric effect, pyroelectric effect, Seebeck effect, etc.) of the element (e.g., piezo-based composite element, pyroelectric-based composite element, thermoelectric-based composite element, etc.).

Thus, in the power-generating system 1, a net generating power can be taken out from the first devices 3 via the second devices 4 as a periodically changing waveform (e.g., alternating current, pulsating current, etc.).

Furthermore, in the power-generating system 1, the temperature of the branch pipe 18a and the branch pipe 18c, and the temperature of the branch pipe 18b and the branch pipe 18d change at the same period, but at a different phase periodically, and therefore a net generating power can be taken out continuously as a periodically changing waveform (e.g., alternating current, pulsating current, etc.).

Then, the exhaust gas passes through the branch pipes 18, and then is supplied to the collection pipe 19. After the collection, the exhaust gas is supplied to the catalyst mount portion 12, and is purified by the catalyst provided in the catalyst mount portion 12. Thereafter, the exhaust gas is supplied to the exhaust pipe 13, and after the noise is reduced in the muffler 14, the exhaust gas is discharged outside through the outlet pipe 15.

At this time, the exhaust gas that passes through the branch pipes 18 is collected in the collection pipe 19, and therefore the temperature of the exhaust gas that passes through the collection pipe 19, the catalyst mount portion 12, the exhaust pipe 13, the muffler 14, and the outlet pipe 15 in sequence is smoothed.

Thus, the temperature of the collection pipe 19, the catalyst mount portion 12, the exhaust pipe 13, the muffler 14, and the outlet pipe 15, which allows the exhaust gas with its temperature smoothed to pass through usually does not go up and down over time, keeping a substantially constant temperature.

Therefore, when the collection pipe 19, the catalyst mount portion 12, the exhaust pipe 13, the muffler 14, or the outlet pipe 15 is used as the heat source 2, and the above-described first devices 3 are disposed at the surrounding thereof with the second device 4 interposed therebetween, the voltage of the net generating power taken out from the first device 3 is small, and also is constant (direct current voltage).

Thus, in such a method, the voltage of the obtained net generating power cannot be increased efficiently with a simple structure, which is disadvantageous in that storage of electricity is inefficient.

On the other hand, as described above, in the power-generating system 1 in which the internal combustion engine 11 (branch pipe 18) is used as the heat source 2, a periodic high-temperature state or low-temperature state is allowed in the first device 3 based on the temperature change over time of the heat source 2, and periodic polarization can be caused in the first device 3 in accordance with the effects (e.g., piezoelectric effect, pyroelectric effect, Seebeck effect, etc.) of the device (e.g., piezo-based composite element, pyroelectric-based composite element, thermoelectric-based composite element, etc.).

Thus, in the power-generating system 1, a net generating power can be taken out from the first devices 3 via the second devices 4 as a periodically changing waveform (e.g., alternating current, pulsating current, etc.).

Thereafter, in this method, for example, as shown by the dotted line in FIG. 7, the voltage of the net generating power obtained as described above is increased in the booster 5 connected to the second device 4 under the state of a periodically changing waveform (e.g., alternating current, pulsating current, etc.), and then after the net generating power with its voltage boosted is converted to a direct current voltage in an alternating current/direct current converter 6, the net generating power is stored in the battery 7. The net generating power stored in the battery 7 is used suitably as a motive power for the automobile 10, or for various electrical accessories mounted in the automobile 10.

In such a power-generating system 1, the heat source 2 having a temporal temperature variation is used, and therefore a changing voltage (e.g., alternating current voltage) can be taken out, and as a result, compared with the case where a constant voltage (direct current voltage) is taken out and converted with a DC-DC converter, excellently efficient boosting of voltage and storage of electricity can be achieved.

Particularly, with such a power-generating system 1, improvement in power generation efficiency can be achieved.

Thus, in such a power-generating system 1, a first device 3 composed of a matrix that is capable of polarization, and a dispersion material having a specific heat capacity that is lower than the specific heat capacity of the matrix is used, and therefore compared with the case where a device that is capable of polarization is simply used as the first device 3, electricity can be generated with excellent efficiency.

Although not shown in detail, in application, the first device 3 can be stacked, as shown in FIG. 5, and furthermore, as shown in FIG. 6, the first device 3 can also be arranged in line on the same plane depending on the types, necessity, and application.

When the first device 3 is stacked and/or arranged in line on the same plane in its application, polarization can be caused in a plurality of first devices 3 simultaneously, and the first devices 3 can be electrically connected in series, and as a result, a high net generating power can be taken out compared with the case where the first device 3 is used singly.

In the description above, the first device 3 is disposed around (outer wall) the branch pipe 18, but the first device 3 is preferably disposed inside (e.g., inner wall) the branch pipe 18 so as to conduct the temperature change to the first device 3 without averaging the temperature.

Examples

<First Embodiment>

EXAMPLE 1

A bulk piezoelectric element (first device, composition: PZT), Curie temperature 295°C, relative dielectric constant: 2130, product number: C-6, manufactured by Fuji ceramics corporation) was cut into a sheet having a size of 50 mm (diameter) $\times$ 1 mm.

Then, a resistance element of 100k$\Omega$ is disposed in series with the piezoelectric element, and a silver paste was applied on the front face and the reverse face thereof to be a size of 50mm (diameter), thereby forming a silver electrode (second device). In this manner, the resistance element of 100k$\Omega$ was interposed between the front face of the piezoelectric element and the silver electrode. The resistance element was provided so as to clearly check electric current characteristics.

Then, the obtained piezoelectric element, resistance element, and silver electrode were heat-treated in an electric furnace at 250°C for 1 hour, thereby producing a sample.

Thereafter, samples were produced in total of four in the same manner, and attached in series on the silver electrodes of each of the samples, and the other side thereof was connected to a digital multimeter.

As the heat source, an engine (3 cylinder :4 cycle) connected to a dynamometer (model number: KF engine, manufactured by Daihatsu Motor Co., Ltd.) was used. One pipe through which the exhaust gas passes through was selected, a box space was formed on the way of the pipe at a position of 2.5m from the engine, and the four samples were disposed.

Then, a thermocouple (temperature sensor) was disposed so that the temperature of the samples can be detected, and an electric field application device (model number: MODEL677B, manufactured by Trek Japan) and a control unit were disposed outside the box space, and they were electrically connected so that an electric field can be applied to inside the box space.

Thereafter, the engine was operated with JC08 mode, and the sample was exposed to the exhaust gas having a temporal temperature variation. In this manner, the temporal temperature variation of the piezoelectric element was obtained and polarization was caused, and the generated voltage (net generating power) was taken out via the electrode and the lead wire.

The temperature (average value) of the samples was measured with a thermocouple, and an electric field (1.5kV/mm) was applied to inside the box space when the temperature became the Curie temperature (295°C) or higher.

Then, the voltage change of the net generating power taken out from the sample was observed with the voltmeter.

In this manner, the engine operation with JC08 mode was repeated 4 cycles.

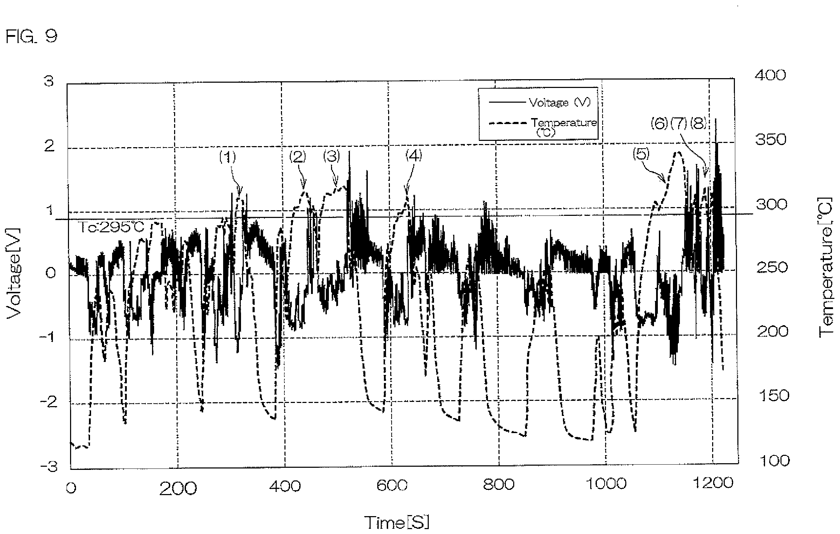

As a result, the sample temperature became the Curie temperature (295°C) or higher to the average of eight times (ref: FIG 9 (1) to (8)) per one cycle with JC08 mode, but no damage was confirmed on the sample, and it was confirmed that excellent power generation performance was kept.

The relationship between the generated voltage and the temperature change per one cycle with JC08 mode is shown in FIG. 9.

<Second Embodiment>

EXAMPLE 2

50g of aluminum oxide ($Al_2O_3$, average particle size (measured with scanning electron microscope) 0.5 $\mu$m) powder, and 12g of platinum oxide ($PtO_2$, average particle size (measured with scanning electron microscope) 2 nm) powder were weighed, and they were mixed by using a ball mill.

Then, the obtained mixture powder was put into a mold of 25 mm $\times$ 25 mm $\times$ 1.2 mm, and pressure molded under 30MPa, and thereafter sintered at 1400°C for 2 hours, thereby producing a composite element.

Then, the silver paste was applied on the front face and on the reverse face of the obtained composite element to give a size of 20 mm $\times$ 20 mm $\times$ 0.1 mm, thereby forming a silver electrode.

Then, the obtained composite element and silver electrode were heat-treated in a normal pressure sintering furnace at 400°C for 2 hours, thereby producing a sample.

Thereafter, using an aluminum tape of 20 mm $\times$ 20 mm, one side of the two lead wires (lead) was attached onto the silver electrodes, and the other side thereof was connected to a digital multimeter.

A heat gun was used as the heat source, and the heat gun and the composite element were positioned so that the jet was directed to the composite element and the jet was distant from the composite element by 5cm.

By blowing hot air from the heat gun, and switching ON/OFF the heat gun over time, the temporal temperature variation of the heat gun and hot air was obtained. This temperature change caused the temporal temperature variation of the composite element and polarization was caused, and the generated voltage (net generating power) was taken out via the electrode and the lead wire.

The temporal temperature variation of the composite element was measured with an infrared thermometer, and the temperature of the hot air was adjusted so that the temperature was 270°C to 380°C.

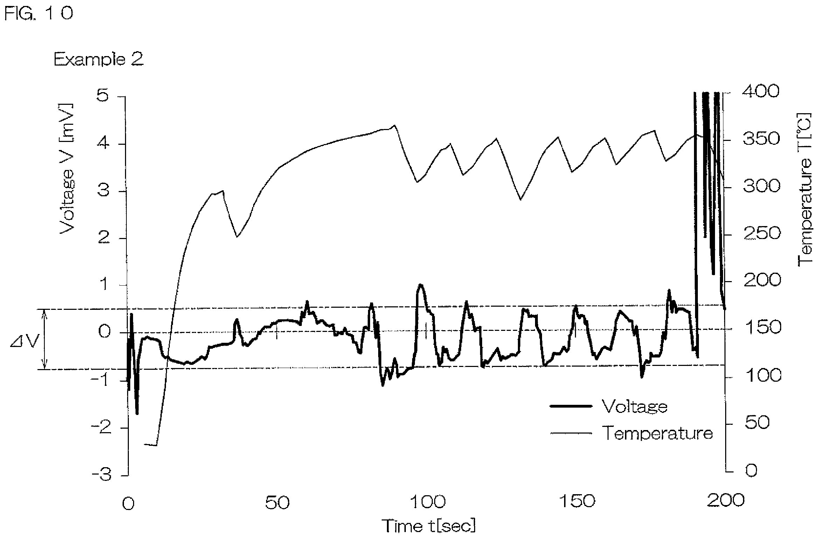

Then, the voltage change of the net generating power taken out from the composite element was observed with the voltmeter. The relationship between the generated voltage and the temperature change is shown in FIG. 10.

EXAMPLE 3

The temporal temperature variation of the composite element was obtained and polarization was caused, and the generated voltage (net generating power) was taken out via the electrode and the lead wire in the same manner as in Example 2, except that 40g of aluminum oxide ($Al_2O_3$, average particle size (measured with scanning electron microscope) 0.5 $\mu$m) powder, and 7.8g of copper oxide (CuO, average particle size (measured with scanning electron microscope) 1.5 nm) powder were mixed.

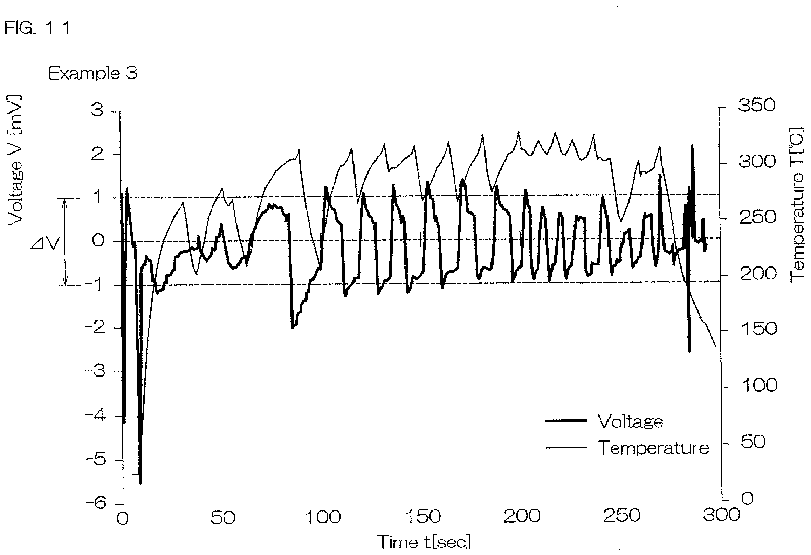

Then, the voltage change of the net generating power taken out from the composite element was observed with the voltmeter. The relationship between the generated voltage and the temperature change is shown in FIG. 11.

Comparative Example 1

The temporal temperature variation of the element was obtained and polarization was caused, and the generated voltage (net generating power) was taken out via the electrode and the lead wire in the same manner as in Example 2, except that the platinum oxide powder was not mixed.

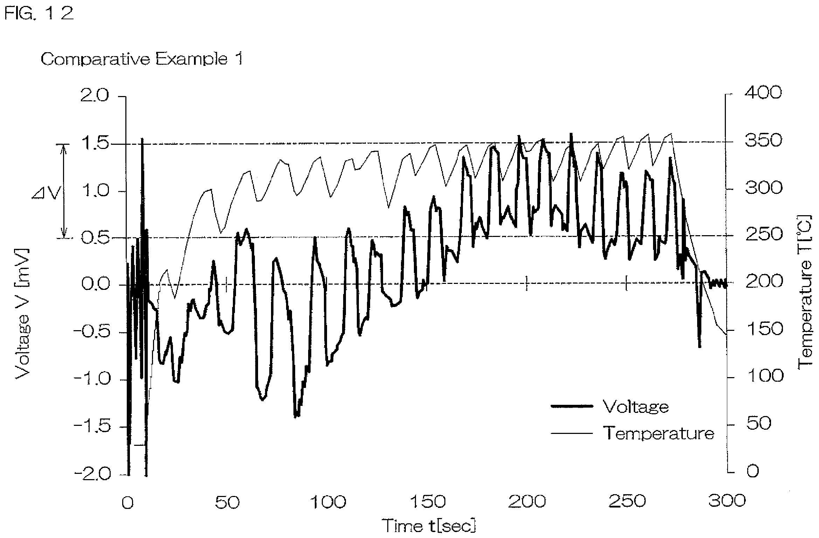

Then, the voltage change of the net generating power taken out from the element was observed with the voltmeter. The relationship between the generated voltage and the temperature change is shown in FIG. 12.

(Examination)

The difference ($\Delta V$) of the generated voltage by the composite element of Example 2 was about 1.3 V (ref: FIG. 10), and the difference ($\Delta V$) of the generated voltage by the composite element of Example 3 was about 2.0 V (ref: FIG. 11).

On the other hand, the difference ($\Delta V$) of the generated voltage by the element of Comparative Example 1 was about 1.0 V, which is lower than the difference ($\Delta V$) in Examples (ref: FIG. 12).

The results confirmed that use of a composite element composed of a matrix that is capable of polarization and a dispersion material having a specific heat capacity that is lower than the specific heat capacity of the matrix allows for excellently efficient power generation compared with the case where an element that is capable of polarization is just used.

While the illustrative embodiments are provided in the above description, such is for illustrative purpose only and it is not to be construed as limiting in any manner. Modification and variation of the present invention that will be obvious to those skilled in the art is to be covered by the following claims.

Industrial Applicability

A power-generating system of the present invention is suitably used in various energy-using devices including a device such as internal combustion engines including an automobiles engine, heat exchanger including a boiler, and air-conditioning equipment, motor generators including a power generator and a motor, and luminous device including lightings.

**Claims**

1. A power-generating system comprising:

   a heat source (2) which is able to produce temporal temperature variation;
   a first device (3) which is able to produce temporal temperature variation based on the temperature change of the heat source and in which polarization occurs,
   a second device (4) for taking out a net generating power from the first device,
   a detection unit (8) that detects the temperature of the first device,
   an electric field application unit (9) that applies an electric field to the first device, **characterised by** a control unit (10) for activating the electric field application unit from the point when the temperature detected by the detection unit is the Curie temperature of the first device or higher until the point when the detected temperature is below the Curie temperature.

**Patentansprüche**

1. Leistungserzeugungssystem, das Folgendes umfasst:

   eine Wärmequelle (2), die fähig ist, eine zeitliche Temperaturschwankung aufzubauen;
   eine erste Vorrichtung (3), die fähig ist, auf der Grundlage der Temperaturänderung der Wärmequelle eine zeitliche Temperaturschwankung aufzubauen, und in der Polarisation auftritt;

eine zweite Vorrichtung (4), um aus der ersten Vorrichtung eine Nettoerzeugungsleistung zu entnehmen,

eine Detektionseinheit (8), die die Temperatur der ersten Vorrichtung detektiert,

eine Einheit (9) zum Anlegen eines elektrischen Felds, die ein elektrisches Feld an die erste Vorrichtung anlegt, **gekennzeichnet durch**

eine Steuereinheit (10), um die Einheit zum Anlegen eines elektrischen Feldes von dem Punkt, an dem die Temperatur, die durch die Detektionseinheit detektiert wird, die Curie-Temperatur der ersten Vorrichtung oder höher ist, bis zu dem Punkt, an dem die detektierte Temperatur unter der Curie-Temperatur ist, einzuschalten.

**Revendications**

1.  Système de génération de puissance comprenant :

    une source de chaleur (2) apte à produire des variations temporelles de température ;
    un premier dispositif (3) apte à produire des variations temporelles de température fondées sur le changement de température de la source de chaleur et dans lequel se produit une polarisation,
    un second dispositif (4) pour extraire une puissance nette générée du premier dispositif,
    une unité de détection (8) qui détecte la température du premier dispositif,
    une unité d'application de champ électrique (9) qui applique un champ électrique au premier dispositif,

    **caractérisé par**

    une unité de commande (10) pour activer l'unité d'application de champ électrique lorsque la température détectée par l'unité de détection est égale à la température Curie du premier dispositif ou plus jusqu'à ce que la température détectée soit inférieure à la température Curie.

FIG. 1

Battery 7

Alternating current/direct
current converter 6

Booster 5

Electric field application device 9
(Electrode)

Second device 4 (Electrode)

Heat
source
2

First device 3

8

Second device 4 (Electrode)

V

Electric field application device
9 (Electrode)

9

Control Unit 10

Power-
generating
system 1

FIG. 2

EP 2 752 985 B1

FIG. 3

FIG. 4

Battery 7

Alternating current/direct
current converter 6

Booster 5

Second device 4

First device 3

Heat source 2

Power-
generating
system 1

FIG. 5

FIG. 6
(a)

(b)

FIG. 7

FIG. 8

FIG. 9

FIG. 1 0

Example 2

FIG. 11

Example 3

FIG. 1 2

Comparative Example 1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H11332266 B
- US 2010289377 A1

- WO 9605474 A